# EUROPÄISCHE PATENTSCHRIFT

(11) **EP 0 596 879 B1**
(45) Veröffentlichungstag und Bekanntmachung des Hinweises auf die Patenterteilung: **05.04.1995**
(21) Anmeldenummer: 91913364.5
(22) Anmeldetag: 01.08.1991
(51) Int. Cl.: H02H 7/26, H02H 3/52, G01R 31/28, G07C 3/00

(54) **VERFAHREN UND ANORDNUNG ZUR FEHLERERKENNUNG IN STROMRICHTERANLAGEN**
PROCESS AND ARRANGEMENT FOR RECOGNIZING DEFECTS IN POWER CONVERTERS
PROCEDE ET DISPOSITIF DE RECONNAISSANCE DE DEFAUTS DANS DES SYSTEMES CONVERTISSEURS

(43) Veröffentlichungstag der Anmeldung: 18.05.1994
(73) Patentinhaber: SIEMENS AKTIENGESELLSCHAFT, 80333 München (DE)
(72) Erfinder: SCHMIDT, Gerhard, D-8520 Erlangen (DE)
(86) Internationale Anmeldenummer: DE9100621
(87) Internationale Veröffentlichungsnummer: WO9303530

(56) Entgegenhaltungen:
- EP-A- 0 280 382
- WO-A-80/00050
- US-A- 4 321 680
- US-A- 4 964 027

## Beschreibung

Die Erfindung betrifft ein Vefahren und eine Anordnung zur Fehlererkennung, insbesondere von Entladungsfehlern, bei einer Umrichteranordnung.

In Stromrichteranlagen, insbesondere Hochspannungsgleichstromübertragungsanlagen, kann es durch Isolations- Leitungs- oder Kontaktfehler zu Teil- oder Glimmentladungen, Glimmen- und Funkenbildung bis hin zu schnell abreissenden Lichtbogenüber-Schlägen kommen. Dabei erwärmen sich die Fehlerstellen, was einen Brand der Anlage zur Folge haben kann.

Die bisher bekannten Verfahren zur Brandverhütung in derartigen Anlagen beruhen auf der Schadensminimierung durch Detektion eines Brand- oder Hitzeherdes mit darauffolgender Abschaltung der Anlage. Als Detektoren werden Rauchgas und Hitzesensoren verwendet, deren Ansprechverhalten und Empfindlichkeit aber einer eindeutigigen und präzisen Fehlererkennung nicht genügen. Es wurde daher auch schon vorgeschlagen, mittels optelektronischer Lichtsensoren, die in großer Stückzahl in der Anlage verteilt sein müssen, oder mittels hochempfindlicher Videosysteme lichtemittierende Fehler zu detektieren. Bei einer weiteren Methode wird mit Hilfe von Lasersystemen die Konsistenz der über der Anlage aufsteigenden Luft überwacht, um Brand- oder Hitzeherde zu erkennen.

Aufgrund der heute erreichten Kompaktheit im Aufbau der Stromrichteranlagen und deren Anordnung im Gebäude stellen diese bekannten Systeme aber einen unmittelbaren Eingriff in die Isolationskoordination dar und können Potentialverläufe der Anlage in störender Weise erheblich beeinflussen.

Der Erfindung liegt die Aufgabe zugrunde, eine Fehlererkennung bei Umrichteranordnungen bereitzustellen, die geeignet ist, Fehler, die zu einem Brand führen könnten, frühzeitig zu erkennen.

Diese Aufgabe wird erfindungsgemäß mit den Merkmalen des Anspruchs 1 gelöst. Auf diese Weise ist eine einfache, zuverlässige Erkennung von brandverursachenden Fehlern möglich. Dabei können bereits vorhandene elektrische Meßstellen und -wandler verwendet werden. Da auf eine optische Fehlererfassung verzichtet wird, sind Fehlerauslösungen durch Fremdlicht und Verschmutzung ausgeschlossen. Es können dabei bereits geringe Teilentladungen bei der Umrichteranordnung erfaßt werden, bevor überhaupt eine Brandgefahr vorliegt.

Vorteilhafterweise werden bei der Frequenzanalyse eine Erhöhung von nichtcharakteristischen harmonischen Signalanteilen im Frequenzspektrum und/oder eine Erhöhung von interharmonischen Signalanteilen im Frequenzspektrum betrachtet. Auf diese Weise ist eine verbesserte Fehlererkennung möglich. Der Erfinder hat nämlich erkannt, daß insbesondere diese Signalanteile bei Fehlern in Umrichteranordnungen erhöht sind und sich daher besonders gut für eine Fehleranalyse eignen.

Die Umrichteranordnung kann dabei zwei Umrichter erfassen, wobei das Signal zwischen den Umrichtern abgegriffen wird. Der Abgriff für das Signal kann dabei bevorzugt an einem Gleichstromzwischenkreis der Umrichteranordnung angeordnet sein. Die Umrichteranordnung ist dabei bevorzugt als Hochspannungsgleichstromübertragungsanlage (HGÜ) ausgebildet. Gemäß den Ansprüchen 4, 5 und 6 bis 8 kann mit Vorteil eine spezielle Fehleranalyse und -auswertung durchgeführt werden, wobei eine Verbesserung der Betriebsführung hinsichtlich einer frühzeitigen Fehlererkennung gegeben ist. Zusätzlich ist eine Gewichtung von Kombinationen von Frequenzanteilen vorteilhaft möglich.

Eine weitere Lösung der Aufgabe ist nach den Merkmalen der Ansprüche 12 bis 20 gegeben, die sich auf eine Schutzeinrichtung beziehen, welche zur Durchführung des vorgenannten Verfahrens dienen. Im Gegensatz zu optischen Schutzeinrichtungen braucht bei der Verwendung dieser Schutzeinrichtung keine Änderung im Aufbau und der Konstruktion der Umrichteranordnung durchgeführt werden, da die Schutzeinrichtung einfach über elektrische Verbindungen an die Umrichteranordnung angeschlossen wird. Bevorzugt weist die Schutzeinrichtung eine Auswerteeinrichtung mit einer Fuzzy-Logic auf.

Ausführungsbeispiele und Vorteile der Erfindung werden nachfolgend anhand der Zeichnung beispielhaft näher erläutert.

Es zeigen:
- FIG 1: eine Schaltungsanordnung zur Fehlererkennung bei einer Umrichteranordnung,
- FIG 2: eine weitere Schaltungsanordnung mit detaillierter Darstellung einer Schutzeinrichtung, und
- FIG 3: ein Diagramm einer Auswertelogik.

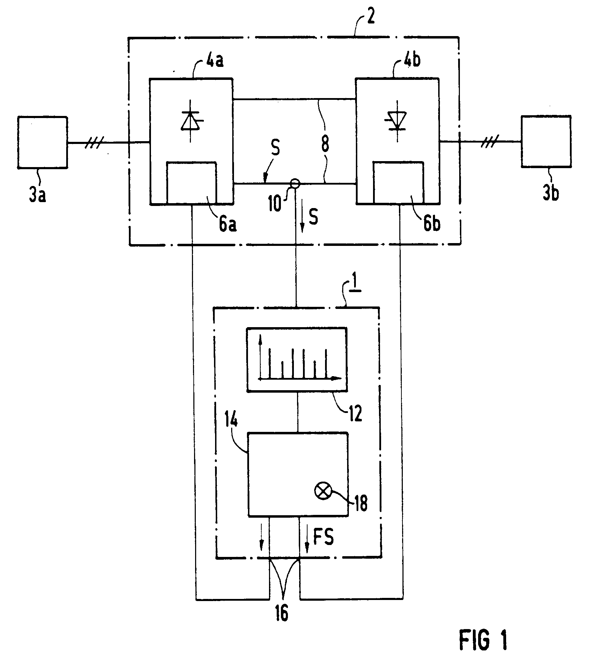

Die Schaltungsanordnung in FIG 1 zeigt eine Schutzeinrichtung 1, die an eine Umrichteranordnung 2 angeschlossen ist. Die beispielhaft gezeigte Umrichteranordnung 2 verbindet zwei Netze 3a, 3b miteinander. Die Umrichteranordnung 2 weist beispielhaft zwei Umrichter 4a, 4b auf, die jeweils eine zugeordnete Steuereinrichtung 6a, 6b umfassen. Die zwei Umrichter 4a, 4b sind über einen Zwischenkreis 8 miteinander verbunden. Über einen Signalgeber 10 wird ein Signal S der Umrichteranordnung 2, vorzugsweise das Signal des Zwischenkreises 8, abgegriffen und der Schutzeinrichtung 1 zugeführt.

Die Schutzeinrichtung 1 umfaßt einen Frequenzanalysator 12, dem das Signal S zugeführt wird. Der Frequenzanalysator 12 ist mit einer Auswerteeinrichtung 14 gekoppelt, die eine Auswertung des vom Frequenzanalysators 12 gemessenen Frequenzspektrums erlaubt.

Im stationären Betrieb der Umrichteranordnung 2 ergibt sich ein charakteristisches Frequenzspektrum des Signals S. Treten jedoch Fehler im Betrieb auf, z.B. durch Glimmen- oder Funkenbildung, so äußern sich diese Fehler in einer Änderung des Frequenzspektrums des Signals S. Die Schutzeinrichtung 1 erkennt diese Änderungen als fehlerbedingt und erzeugt darauf ein Fehlersignal FS, das an einem Ausgang 16 abgegeben wird. Bevorzugt werden dabei Frequenzen im KHz-Bereich analysiert und als Fehlerkriterium herangezogen. Alternativ oder zusätzlich kann das Fehlersignal auch einer Anzeigevorrichtung 18 zugeführt werden, die den Fehler dann signalisiert. Das Fehlersignal FS kann dann an weitere elektrische Einrichtungen geführt werden um eine Beseitigung des aufgetretenen Fehlers z.B. einen eingeschränkten Betrieb zu veranlassen. Beispielhaft sind dazu in FIG 1 die Ausgänge 16 mit den Steuereinrichtungen 6a, 6b der Umrichter 4a und 4b verbunden. Auf diese Weise kann z.B. eine Abschaltung der Umrichteranordnung 2 oder auch eine spannungsbegrenzende Maßnahme, welche wiederum eine Unterdrückung von Fehlern zur Folge hat, eingeleitet werden.

Meßsignale von netzgeführten Umrichteranordnungen in Ventiltechnik (z.B. Thyristoren) weisen in der Regel ein Frequenzspektrum auf, das bevorzugt die Vielfachen ihrer Pulszahl I aufweisen. Als charakteristische Frequenzen treten wechselspannungsseitig dabei die ((Ixn) ± 1) -fachen auf (z.B. bei einer 12-Pulsschaltung: 11, 13., 23., 25., 35., ... usw.), wohingegen gleichspannungsseitig die (Ixn) -fachen auftreten (12,24,36 usw.).

Zusätzlich treten im Frequenzspektrum nichtcharakteristische Frequenzen oder sogenannte Interharmonische auf, welche durch Unsymmetrien innerhalb der Umrichteranordnung entstehen und im Normalbetrieb vernachlässigbar gering sind.

Treten im Betrieb diese betriebsunüblichen Frequenzen im Frequenzspektrum auf, so ist dies ein Zeichen dafür, daß ein Fehler in der Umrichteranordnung vorhanden ist. Insbesondere bei Entladungsfehlern jeglicher Art tritt nämlich ein breitbandiges Frequenzspektrum auf, das bei dem vorliegenden Verfahren und der danach arbeitenden Schutzeinrichtung 1 erfaßt und ausgewertet wird. Auf diese Weise können bereits geringste Entladungen erkannt und Maßnahmen eingeleitet werden, die einen Brand verhindern.

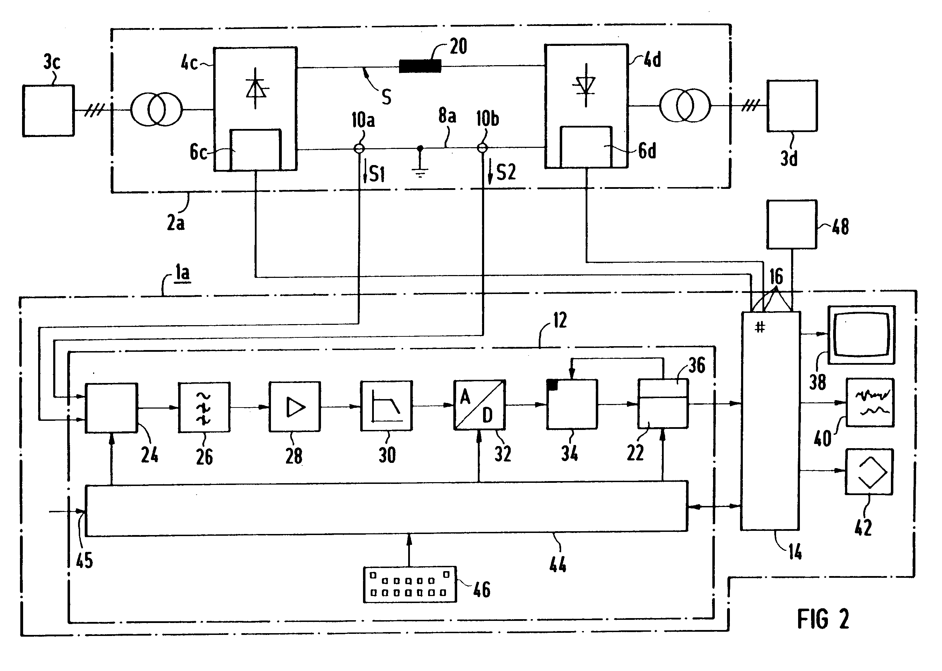

In FIG 2 ist zunächst eine Umrichteranordnung 2a gezeigt, die als Hochspannungsgleichstromübertragungsanlage (Kurzkupplung oder Fernübertragung) ausgebildet ist. Diese verbindet zwei als Drehstromnetze ausgebildete Netze 3c, 3d, wobei beispielsweise bei einem Leistungstransport vom Netz 3c nach Netz 3d der Umrichter 4c als Gleichrichter und der Umrichter 4d als Wechselrichter ausgebildet sind. Der Zwischenkreis 8a führt ein Gleichstromsignal. In den Zwischenkreis 8a ist zusätzlich zumindest eine Glättungsdrossel 20 eingefügt. Über Signalgeber 10a, 10b wird das Signal S des Zwischenkreises 8a als Meßsignal S1, S2 der Schutzeinrichtung 1a zugeführt.

Wesentliches Funktionsglied der Schutzeinrichtung la ist ein Fast-Fourier-Transformations Glied (FFT), das die eigentliche Analyse des Frequenzspektrums des Signals S durchführt. Beispielhaft ist hier ein Aufbau gezeigt, der eine mögliche Meßwertvorbereitung für das FFT-Glied 22 vorsieht. Demnach werden die Meßsignale S1, S2 zunächst einem Multiplexer 24 zugeführt. Dies ist günstig, wenn bei der Verarbeitung von mehreren Meßwerten nur ein Analog-Digital-Wandler vorgesehen werden soll. Das vom Multiplexer 24 abgegebene Signal wird dann zur Unterdrückung eines Gleichanteils einem Hochpaßfilter 26 zugeführt und anschließend von einem Verstärker 28 verstärkt. Zur Bandbegrenzung kann ein an eine Abtastfrequenz des Analog-Digital-Wandlers angepaßtes Anti-Aliasing-Filter 30 vorgesehen werden.

Es folgt darauf der Analog-Digital-Wandler 32, welcher zur Digitalisierung des Signales S verwendet wird. Dieser kann auch ein sogenanntes Sample & Hold-Glied umfassen. Eine Abspeicherung der digitalisierten Meßdaten erfolgt in einem schnellen Speicher 34, der von einem dem FFT-Glied 22 zugeordneten Prozessor 36 verwaltet wird.

Die FFT-Analyse im FFT-Glied 22 liefert abhängig von der gewählten Abtastschrittbreite, Fensterbreite und Anordnung ein Frequenzspektrum, das dann von der Auswerteeinrichtung 14 frequenzselektiv ausgewertet werden kann. Hierbei können die nichtcharakteristischen und interharmonischen Stromanteile des Signals S getrennt oder als gewichtete Summe als Fehlerkriterium herangezogen werden. Zur Signalisierung oder zur Ausgabe kann beispielsweise ein Monitor 38, ein Plotter 40, oder ein Datenspeicher 42 vorgesehen sein. Des weiteren kann auch das Fehlersignal FS direkt an ein übergeordnetes Schutzsystem zur weiteren Fehlerbehandlung oder auch an die Steuereinrichtungen 6c, 6d der Umrichter 4c, 4d weitergeleitet werden.

Für eine übergeordnete Steuerung oder Regelung kann eine Programmsteuerung 44 vorgesehen sein, die mit einer übergeordneten Anlagensteuerung synchronisiert ist und die gesamte Meßwerterfassung und Auswertung koordiniert. Zusätzliche Eingaben oder Auswertungen können über ein Bedienfeld 46 durchgeführt werden. Mit Hilfe der Programmsteuerung 44 können auch in Abhängigkeit von jeweils ausgewählten Änderungen des Frequenzspektrums zugeordnete Fehlersignale erzeugt werden, so daß je nach Fehlerart, die sich in unterschiedlichen Änderungen des Frequenzspektrums wiederspiegeln, verschiedene Reaktionen der Umrichteranordnung möglich sind.

Das Verfahren ist unabhängig vom Typ der Umrichteranordnung (z.B. Mono-/Bipol, Multiterminal, Kurzkopplung, Fernübertragung), da es nur ein gemeinsames Signal auswertet. In der Praxis ergeben sich die folgenden Vorteile:
- Es können die für die Steuerung und Regelung der Umrichteranordnung vorhandenen Meßstellen und -wandler verwendet werden,
- es erfolgt keine Änderung im Aufbau und der Konstuktion von Ventiltürmen bzw. Betriebsräumen,
- eine Fehlauslösung durch Fremdlicht, Verschmutzung o.ä. ist z.B. gegenüber optischen Einrichtungen ausgeschlossen.

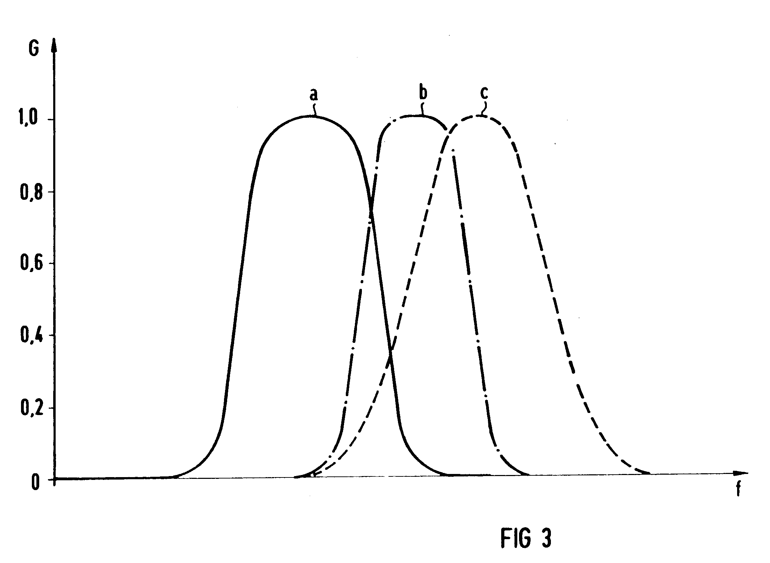

Die Frequenzanalyse kann auch mit Hilfe einer Fuzzy-Logic erfolgen. Dazu kann beispielsweise die Auswerteeinrichtung 14 eine Fuzzy-Logic umfassen, mit der eine Gewichtung von Signalanteilen im Frequenzspektrum durchgeführt wird. Auf diese Weise können auch kritische Frequenzspektren als fehlerbedingt erkannt werden. Dies gilt insbesondere für Signalkombinationen, bei denen die jeweils einzeln auftretenden Frequenzen zwar noch keinen Fehler erkennen lassen, aber durch die gewichtete Summe sehr wohl ein Fehler erkennbar ist. In FIG 3 ist hierzu ein Diagramm gezeigt, das beispielhaft eine Gewichtung von Signalanteilen zeigt. Auf den Diagrammachsen sind die Frequenz f und die Gewichtung G aufgetragen. Die Kurve b zeigt einen normalen Betriebsfall. Mit a und c sind beispielsweise ein schwerer bzw. ein leichter Fehlerfall dargestellt. Eine Anpassung der Gewichtung muß für den speziellen Anwendungsfall vorgesehen werden.

## Patentansprüche

1. Verfahren zur Fehlererkennung, insbesondere von Entladungsfehlern, bei einer Umrichteranordnung (2,2a), bei dem zumindest ein von der Umrichteranordnung (2,2a) gewonnenes Signal (S) einer Frequenzanalyse unterzogen wird und beim Erkennen einer fehlerbedingten Änderung im Frequenzspektrum des Signals (S) ein Fehlersignal (FS) erzeugt wird.

2. Verfahren nach Anspruch 1, bei dem als fehlerbedingte Änderung eine Erhöhung von nichtcharakteristischen harmonischen Signalanteilen im Frequenzspektrum des Signals (S) gilt.

3. Verfahren nach Anspruch 1 oder 2, bei dem als fehlerbedingte Änderung eine Erhöhung von interharmonischen Signalanteilen im Frequenzspektrum des Signals (S) gilt.

4. Verfahren nach einem der Ansprüche 1 bis 3, wobei das Erkennen einer fehlerbedingten Änderung mit Hilfe einer Fuzzy-Logic erfolgt.

5. Verfahren nach Anspruch 4, bei dem eine Gewichtung der Signalanteile für die Bildung des Fehlersignals (FS) in der Fuzzy-Logic erfolgt.

6. Verfahren nach einem der Ansprüche 1 bis 5, bei dem die Umrichteranordnung zwei Umrichter (4a,4b,4c,4d) umfaßt, wobei das Signal (S) zwischen den zwei Umrichtern (4a,4b,4c,4d) gewonnen wird.

7. Verfahren nach Anspruch 6, bei dem die zwei Umrichter (4a,4b,4c,4d) über einen Gleichstromzwischenkreis (8,8a) miteinander verbunden sind, an dem das Signal (S) abgegriffen wird.

8. Verfahren nach einem der Ansprüche 1 bis 7, bei dem in Abhängigkeit von jeweils ausgewählten Änderungen des Frequenzspektrums zugeordnete Fehlersignale (FS) erzeugt werden.

9. Verfahren nach einem der Ansprüche 1 bis 8, bei dem das bzw. die Fehlersignal/e (FS) einer Anzeigeeinrichtung (18,38, 48) zugeführt wird/werden.

10. Verfahren nach einem der Ansprüche 1 bis 9, bei dem das/die Fehlersignal/e (FS) einer Steuereinrichtung (6a,6b,6c,6d) der Umrichteranordnung (2,2a) zugeführt wird/werden, wobei zumindest ein Betriebsparameter der Umrichteranordnung (2,2a) geändert wird.

11. Verfahren nach einem der Ansprüche 1 bis 10, wobei die Umrichteranordnung (2,2a) als Hochspannungsgleichstromübertragungsanlage ausgebildet ist.

12. Schutzeinrichtung zur Fehlererkennung für eine Umrichteranordnung (2,2a), umfassend einen Frequenzanalysator (12) mit einer Auswerteeinrichtung (14), dem ein Signal (S) der Umrichteranordnung (14) zuführbar ist, wobei die Auswerteeinrichtung (14) ein Fehlersignal (FS) erzeugt, wenn mittels des Frequenzanalysators (12) im Frequenzspektrum des Signals (S) eine fehlerbedingte Änderung erkannt wird.

13. Schutzeinrichtung nach Anspruch 12, wobei als fehlerbedingte Änderung eine Erhöhung von nichtcharakteristischen harmonischen Signalanteilen im Frequenzspektrum des Signals (S) gilt.

14. Schutzeinrichtung nach Anspruch 12 oder 13, wobei als fehlerbedingte Änderung eine Erhöhung von interharmonischen Signalanteilen im Frequenzspektrum des Signals (S) gilt.

15. Schutzeinrichtung nach einem der Ansprüche 12 bis 14, wobei das Signal (S) ein Gleichstromsignal eines Gleichstromzwischenkreises der Umrichteranordnung (2,2a) ist.

16. Schutzeinrichtung nach einem der Ansprüche 12 bis 15, wobei die Auswerteeinrichtung (14) eine Auswahllogik umfaßt, die bei jeweils ausgewählten Änderungen im Frequenzspektrum des Signals (S) zuordbare Fehlersignale (FS) erzeugt.

17. Schutzeinrichtung nach einem der Ansprüche 12 bis 16, wobei die Auswerteeinrichtung (14) eine Fuzzy-Logic umfaßt.

18. Schutzeinrichtung nach einem der Ansprüche 10 bis 17, wobei das bzw. die Fehlersignal/e (FS) einer Anzeigeeinrichtung (18,38,48) zuführbar ist/sind.

19. Schutzeinrichtung nach einem der Ansprüche 10 bis 18, wobei das/die Fehlersignal/e (FS) einer Steuereinrichtung (6a, 6b,6c,6d) der Umrichteranordnung (2,2a) zuführbar ist/sind, wodurch zumindest ein Betriebsparameter der Umrichteranordnung (2,2a) geändert wird.

20. Schutzeinrichtung nach einem der Ansprüche 10 bis 19, wobei die Umrichteranordnung (2,2a) als Hochspannungsgleichstromübertragungsanlage ausgebildet ist.

## Claims

1. Method for detecting faults, in particular discharge faults, in a converter arrangement (2, 2a), in which at least one signal (S) obtained from the converter arrangement (2, 2a) is subjected to a frequency analysis and a fault signal (FS) is generated upon detection of a change in the frequency spectrum of the signal (S) caused by a fault.

2. Method according to Claim 1, in which an increase of non-characteristic harmonic signal components in the frequency spectrum of the signal (S) is valid as a change caused by a fault.

3. Method according to Claim 1 or 2, in which an increase of interharmonic signal components in the frequency spectrum of the signal (S) is valid as a change caused by a fault.

4. Method according to one of Claims 1 to 3, in which a change caused by a fault is detected with the aid of fuzzy logic.

5. Method according to Claim 4, in which the signal components for the formation of the fault signal (FS) are weighted in the fuzzy logic.

6. Method according to one of Claims 1 to 5, in which the converter arrangement contains two converters (4a, 4b, 4c, 4d), the signal (S) being obtained between the two converters (4a, 4b, 4c, 4d).

7. Method according to Claim 6, in which the two converters (4a, 4b, 4c, 4d) are connected to one another via a direct current link (8, 8a), at which the signal (S) is picked up.

8. Method according to one of Claims 1 to 7, in which assigned fault signals (FS) are generated depending on respective selected changes in the frequency spectrum.

9. Method according to one of Claims 1 to 8, in which the fault signal(s) (FS) is(are) fed to an indicating device (18, 38, 48).

10. Method according to one of Claims 1 to 9, in which the fault signal(s) (FS) is(are) fed to a control device (6a, 6b, 6c, 6d) of the converter arrangement (2, 2a), at least one operating parameter of the converter arrangement (2, 2a) being changed thereby.

11. Method according to one of Claims 1 to 10, in which the converter arrangement (2, 2a) is designed as a high-voltage direct current transmission system.

12. Protective device for detecting faults in a converter arrangement (2, 2a), containing a frequency analyser (12) with an evaluation device (14), to which a signal (S) of the converter arrangement (2, 2a) can be fed, the evaluation device (14) generating a fault signal (FS) when a change caused by a fault is detected in the frequency spectrum of the signal (S) by means of the frequency analyser (12).

13. Protective device according to Claim 12, in which an increase of non-characteristic harmonic signal components in the frequency spectrum of the signal (S) is valid as a change caused by a fault.

14. Protective device according to Claim 12 or 13, in which an increase of interharmonic signal components in the frequency spectrum of the signal (S) is valid as a change caused by a fault.

15. Protective device according to one of Claims 12 to 14, in which the signal (S) is a direct current signal of a direct current link of the converter arrangement (2, 2a).

16. Protective device according to one of Claims 12 to 15, in which the evaluation device (14) contains selection logic which generates assignable fault signals (FS) in the case of respective selected changes in the frequency spectrum of the signal (S).

17. Protective device according to one of Claims 12 to 16, in which the evaluation device (14) contains fuzzy logic.

18. Protective device according to one of Claims 10 to 17, in which the fault signal(s) (FS) can be fed to an indicating device (18, 38, 48).

19. Protective device according to one of Claims 10 to 18, in which the fault signal(s) (FS) can be fed to a control device (6a, 6b, 6c, 6d) of the converter arrangement (2, 2a), at least one operating parameter of the converter arrangement (2, 2a) being changed as a result.

20. Protective device according to one of Claims 10 to 19, in which the converter arrangement (2, 2a) is designed as a high-voltage direct current transmission system.

## Revendications

1. Procédé d'identification de défauts, notamment de défauts de décharge, dans un dispositif convertisseur (2,2a), dans lequel au moins un signal (S), obtenu dans le dispositif convertisseur (2,2a), est soumis à une analyse de fréquence et, lors de l'identification d'une modification, conditionnée par un défaut, du spectre des fréquences du signal (S), un signal de défaut (FS) est produit.

2. Procédé suivant la revendication 1, selon lequel comme modification conditionnée par un défaut, on considère un accroissement de composantes harmoniques non caractéristiques du signal dans le spectre des fréquences du signal (S).

3. Procédé suivant la revendication 1 ou 2, selon lequel comme variation provoquée par un défaut, on utilise un accroissement de composantes interharmoniques du signal dans le spectre des fréquences du signal (S).

4. Procédé suivant l'une des revendications 1 à 3, selon lequel l'identification d'une modification due à un défaut, est réalisée à l'aide d'une "Fuzzy-Logic", c'est-à-dire une logique floue.

5. Procédé suivant la revendication 4, selon lequel une pondération des composantes du signal est réalisée dans la logique floue pour la formation du signal de défaut (FS).

6. Procédé suivant l'une des revendications 1 à 5, selon lequel le dispositif convertisseur comprend deux convertisseurs (4a,4b,4c,4d), le signal (S) étant obtenu entre les deux convertisseurs (4a,4b,4c,4d).

7. Procédé suivant la revendication 6, selon lequel les deux convertisseurs (4a,4b,4c,4d) sont reliés entre eux par un circuit intermédiaire à courant continu (8,8a), dans lequel est prélevé le signal (S).

8. Procédé suivant l'une des revendications 1 à 7, selon lequel en fonction de variations respectivement sélectionnées du spectre des fréquences sont produits des signaux de défauts associés (FS).

9. Procédé suivant l'une des revendications 1 à 8, selon lequel le ou les signaux de défauts (FS) sont envoyés à un dispositif d'affichage (18,38,48).

10. Procédé suivant l'une des revendications 1 à 9, selon lequel le/les signaux de défauts (FS) sont envoyés à un dispositif de commande (6a,6b,6c,6d) du dispositif convertisseur (2,2a), auquel cas au moins un paramètre de service du dispositif convertisseur (2,2a) est modifié.

11. Procédé suivant l'une des revendications 1 à 10, selon lequel le dispositif convertisseur (2,2a) est réalisé sous la forme d'une installation de transmission à courant continu et à haute tension.

12. Dispositif de protection pour l'identification de défauts pour un dispositif convertisseur (2,2a), comprenant un analyseur de fréquence (12) équipé d'un dispositif d'évaluation (14), auquel peut être envoyé un signal (S) du dispositif convertisseur (14), le dispositif d'évaluation (14) produisant un signal de défaut (FS) lorsqu'une modification conditionnée par un défaut est identifiée au moyen d'un analyseur de fréquence (12) dans le spectre de fréquence du signal (S).

13. Dispositif de protection suivant la revendication 12, dans lequel comme variation due à un défaut on considère un accroissement d'une composante harmonique non caractéristique du signal (S) dans le spectre de fréquences de ce dernier.

14. Dispositif de protection suivant la revendication 12 ou 13, selon lequel comme variation due à un défaut on considère un accroissement de composantes inter-harmoniques du signal (S) dans le spectre des fréquences de ce dernier.

15. Dispositif de protection suivant l'une des revendications 12 à 14, selon lequel le signal (S) est un signal à courant continu d'un circuit intermédiaire à courant continu du dispositif convertisseur (2,2a).

16. Dispositif de protection suivant l'une des revendications 12 à 15, dans lequel le dispositif d'évaluation (14) comprend une logique de sélection, qui, dans le cas de variations respectivement sélectionnées dans le spectre des fréquences du signal (S), produit des signaux de défauts pouvant être associés (FS).

17. Dispositif de protection suivant l'une des revendications 12 à 16, dans lequel le dispositif d'évaluation (14) comprend une logique floue.

18. Dispositif de protection suivant l'une des revendications 10 à 17, selon lequel le ou les signaux de défauts (FS) peuvent être envoyés à un dispositif d'affichage (18,38,48).

19. Dispositif de protection suivant l'une des revendications 10 à 18, selon lequel le ou les signaux de défauts (FS) peuvent être envoyés à un dispositif de commande (6a,6b,6c,6d) du dispositif convertisseur (2,2a), ce qui a pour effet qu'au moins un paramètre de service du dispositif convertisseur (2,2a) est modifié.

20. Dispositif de protection suivant l'une des revendications 10 à 19, dans lequel le dispositif convertisseur (2,2a) est réalisé sous la forme d'une installation de transmission à courant continu et à haute tension.
